## Europäisches Patentamt
## European Patent Office
## Office européen des brevets

(11) Veröffentlichungsnummer : **0 025 505
B1**

(12) **EUROPÄISCHE PATENTSCHRIFT**

(45) Veröffentlichungstag der Patentschrift :
05.06.85

(21) Anmeldenummer : 80104638.4

(22) Anmeldetag : 06.08.80

(51) Int. Cl.⁴ : **C 08 K 5/24**, C 07 C109/10,
C 08 L 23/02

(54) **N.N'-Bis-salicyloyl-hydrazin als Metalldesaktivator.**

(30) Priorität : 21.08.79 DE 2933870

(43) Veröffentlichungstag der Anmeldung :
25.03.81 Patentblatt 81/12

(45) Bekanntmachung des Hinweises auf die Patenterteilung : 05.06.85 Patentblatt 85/23

(84) Benannte Vertragsstaaten :
AT CH DE FR GB IT LI SE

(56) Entgegenhaltungen :
DE-A- 2 703 558
FR-A- 2 186 461
US-A- 3 849 492
US-A- 3 931 103
US-A- 4 012 360
Die Akte enthält technische Angaben, die nach dem
Eingang der Anmeldung eingereicht wurden und die
nicht in dieser Patentschrift enthalten sind.

(73) Patentinhaber : **Siemens Aktiengesellschaft
Berlin und München Wittelsbacherplatz 2
D-8000 München 2 (DE)**

(72) Erfinder : **von Gentzkow, Wolfgang Dr.
Schellenberg 57
D-8524 Kleinsendelbach (DE)**
Erfinder : **Rubner, Roland, Dr.
Buchenring 15
D-8551 Röttenbach (DE)**

**Beschreibung**

Die Erfindung betrifft die Verwendung von N.N'-Bis-salicyloyl-hydrazin als Metalldesaktivator für mit Kupfer in Berührung stehende oder Kupfer bzw. Kupferionen enthaltende organische Materialien.

Viele organische Materialien, insbesondere Polymere wie Polyolefine, aber auch andere Polymere, wie Polyoxymethylen, Polyamid und ungesättigte Polyesterharze, die heutzutage in der Elektrotechnik für Isolationszwecke verwendet werden, unterliegen in Gegenwart von Kupfer einer beschleunigten thermooxidativen Alterung. Dadurch verschlechtern sich ihre elektrischen und mechanischen Dauergebrauchseigenschaften beträchtlich. Besonders gravierend wird der schädigende Einfluß des Kupfers bei erhöhten Temperaturen, da die Alterungsgeschwindigkeit der Polymeren mit steigenden Temperaturen stark zunimmt.

Insbesondere vernetzte Polyolefine, die in zunehmendem Umfang als Isoliermaterial für Kabel und Leitungen eingesetzt werden, unterliegen in Gegenwart von Kupfer einer stark beschleunigten Alterung und müssen deshalb wirksam gegen den oxidationsbeschleunigenden Einfluß von Kupfer geschützt werden. Dies kann erfahrungsgemäß durch Einbringen einer Folie als Trennschicht zwischen Kupferleiter und Isolierung geschehen oder durch Verwendung verzinnter Leiter ; dadurch wird der direkte Kupferkontakt der Isolierung vermieden. Derartige Maßnahmen sind jedoch teuer und fertigungstechnisch sehr aufwendig. So sind beispielsweise beim Einsatz einer Folie als Trennschicht, insbesondere bei kleinen Leiterquerschnitten, nur geringe Fertigungsgeschwindigkeiten möglich.

Ein weiterer, verfahrenstechnisch einfacher Weg zur Erzielung der gewünschten Anforderungen an die Qualität und die Temperaturbelastbarkeit von Polymerwerkstoffen in Kontakt mit Kupfer beinhaltet die Verwendung sogenannter Kupferdesaktivatoren, die die oxidationsbeschleunigende Wirkung von Kupfer auch bei erhöhten Temperaturen inhibieren. Die Stabilisierung von Polymermaterialien durch Kupferdesaktivatoren ist somit eine kostengünstige Maßnahme.

Aus der US-Patentschrift 3 849 492 ist es bekannt, Metalldesaktivatoren auf der Basis von N.N'-Bis-salicyloylhydrazin zu verwenden. Dabei sollen sich insbesondere mehrfach alkyl- oder alkoxysubstituierte Derivate der Basisverbindung für die Stabilisierung von Polyolefinen gegen die schädigende Wirkung von Kupfer und anderen Übergangsmetallen als wirksam erwiesen haben.

Aus der deutschen Auslegeschrift 27 03 558 ist es bekannt (vgl. Spalte 2, Zeilen 49 bis 65), daß zur dauerhaften Stabilisierung von mit Kupfer in Berührung stehenden Polymeren eine Kombination aus N.N'-Bis-salicyloyl-hydrazin als Metalldesaktivator und oligomerem 2.2.4-Trimethyl-1.2-dihydrochinolin als Oxidationsinhibitor technisch vorteilhaft ist. Diese Stabilisatorkombination hat sich auf für die Stabilisierung vernetzter Polyolefine als besonders wirksam erwiesen. Die gute Wirksamkeit von N.N'-Bis-salicyloyl-hydrazin als Metalldesaktivator wurde dabei aufgrund umfangreicher Untersuchungen an Modelladern und anhand von Alterungsversuchen an technischen Produkten ermittelt.

Als Metalldesaktivator diente in der genannten Stabilisatorkombination ein Produkt, welches durch Umsetzung von technischem Salicylsäurehydrazid mit technischer Salicylsäure unter Zugabe von technischem Thionylchlorid und Pyridin in technischem Chlorbenzol direkt erhalten wurde und nach Reinigung durch Auswaschen mit Alkohol in einem Reinheitsgrad von 99 % vorlag (vgl. britische Patentschrift 1 398 360).

Die Einarbeitung eines Metalldesaktivators der genannten Art sowie von weiteren Additiven in einen Polymerwerkstoff, wie beispielsweise in ein Polyolefin für Kabel- und Leitungsisolierungen, erfolgt im technischen Maßstab durch übliche Mischverfahren. In der Kabel- und Leitungstechnik werden dabei bevorzugt zunächst sogenannte Konzentrate, bestehend aus Metalldesaktivator bzw. anderen Additiven und Polymermaterial, hergestellt, die dann durch Einmischen in weiteres Polymermaterial zu Isoliermischungen mit den gewünschten Konzentrationen an Metalldesaktivator und den weiteren Additiven verarbeitet werden.

Bei der Herstellung der Konzentrate mit dem auf die genannte Weise hergestellten Metalldesaktivator im technischen Maßstab hat sich gezeigt, daß bei den damit befaßten Personen Augenreizungen bzw. Augenschädigungen auftreten können. Diese Augenreizungen bzw. -schädigungen konnten auf den verwendeten Metalldesaktivator zurückgeführt werden.

Zur Vermeidung von Augenreizungen und Augenschädigungen wurde deshalb versucht, als Metalldesaktivator ein nach bekannten Methoden aus Salicylsäurechlorid und Hydrazin bzw. aus Salicylsäurechlorid und Salicylsäurehydrazid hergestelltes und durch Umkristallisieren gereinigtes N.N'-Bis-salicyloyl-hydrazin einzusetzen, dessen Massegehalt an Chlor ≤ 0,002 %, dessen Massegehalt an Schwefel ≤ 0,07 % und dessen Gesamtacidität (an einbasischer Säure) ≤ 0,4 mmol/kg betrug. Diese maximal zulässigen Gehalte an Verunreinigungen wurden durch Tierversuche bestimmt. Dazu wurden Kaninchen Extrakte unterschiedlich reiner Produkte von N.N'-Bis-salicyloylhydrazin in isotonischer Kochsalzlösung über einen Zeitraum von 3 Wochen appliziert (Testmethode 1), da von der Annahme ausgegangen wurde, daß nur die in der Körperflüssigkeit löslichen Bestandteile schädigend wirken.

Bei einer veränderten und drastisch verschärften Testmethode (Testmethode 2), bei der die feste Substanz in relativ kurzen Zeitabständen, d. h. Tagen, mehrfach direkt in das Auge von Versuchstieren (Kaninchen) eingebracht wurde, wurden nun auch bei einem derartigen Produkt starke Reizerscheinungen festgestellt. Diese — auch in nachstehendem Zusammenhang unter verschärften Bedingungen durchgeführte — Untersuchungsmethode geht davon aus, daß der Metalldesaktivator in fester Form, beispielsweise als Staub, in das Auge gelangen kann.

Aufgabe der Erfindung ist es, zur Verwendung als Metalldesaktivator für mit Kupfer in Berührung stehende oder Kupfer bzw. Kupferionen enthaltende organische Materialien ein N.N'-Bis-salicyloyl-hydrazin bereitzustellen, das aufgrund einer wesentlich verminderten Augenreizung eine gefahrlose Verarbeitung in der Technik ermöglicht.

Dies wird erfindungsgemäß durch ein N.N'-Bis-salicyloyl-hydrazin erreicht, das aus Salicylsäurealkylester und Hydrazin oder aus Salicylsäurealkylester und Salicylsäurehydrazid, gegebenenfalls in Gegenwart eines Katalysators, hergestellt ist.

Es wurde nämlich überraschenderweise gefunden, daß bei der genannten Testmethode 2 Augenreizungen bzw. Augenschädigungen nurmehr in stark verminderter Form auftreten, wenn ein N.N'-Bis-salicyloyl-hydrazin zum Einsatz gelangt, das durch Umsetzung von Salicylsäurealkylester mit Hydrazin bzw. Salicylsäurehydrazid gewonnen wird. Die Umsetzung, bei der kein Salicylsäurechlorid verwendet wird, kann dabei durch nukleophile und/oder elektrophile Katalysatoren beschleunigt werden, wobei eine nukleophile Katalyse bevorzugt wird. Als Katalysatoren dienen insbesondere primäre, sekundäre oder tertiäre Amine sowie aminogruppenhaltige Verbindungen, wie beispielsweise stickstoffhaltige Heterocyclen, Amide und Hydrazide, oder die Ammoniumsalze dieser Amine und aminogruppenhaltigen Verbindungen mit anorganischen oder organischen Säuren. Das bei der genannten Umsetzung anfallende Rohprodukt kann gegebenenfalls nach üblichen Reinigungsmethoden, wie Umkristallisieren, weiter aufgearbeitet werden.

Der erfindungsgemäß verwendete Metalldesaktivator wird besonders vorteilhaft im Gemisch mit üblichen phenolischen oder aminischen Oxidationsinhibitoren zur Stabilisierung von organischen Materialien, insbesondere von Kunststoffen und Kunststoffvorprodukten, gegen oxidativen Abbau eingesetzt. Eine besonders synergistische Wirkung wird im Gemisch mit oligomeren 2.2.4-Trimethyl-1.2-dihydrochinolin erzielt. Die Verarbeitung des erfindungsgemäß verwendeten Metalldesaktivators zur Stabilisierung von Kunststoffen kann nach der üblichen Mischtechnik, beispielsweise über Konzentrate, insbesondere aber auch durch Direktdosierung eines phlegmatisierten, d. h. durch geeignete flüssige Zusätze verarbeitungsfreundlicher eingestellten, Metalldesaktivators erfolgen.

Gemäß der Erfindung können insbesondere vernetzte und unvernetzte Thermoplaste, wie vernetzte und unvernetzte Polyolefine, und Elastomere sowie Reaktionsharze in gehärtetem und ungehärtetem Zustand vorteilhaft gegen schädliche katalytische Einflüsse von Kupfer geschützt werden. Polymere, die den erfindungsgemäß verwendeten Metalldesaktivator enthalten, können besonders vorteilhaft als Kabel- und Leitungsisolierungen in der Starkstromtechnik und Nachrichtentechnik eingesetzt werden. Darüber hinaus kann der erfindungsgemäß verwendete Metalldesaktivator auch zur Stabilisierung von Polymerwerkstoffen, von Isolierölen und von Schmierfetten, die mit Kupfer in Kontakt stehen oder Kupferionen enthalten, Verwendung finden. Derartige Isolieröle und Schmierfette gelangen insbesondere in der Elektrotechnik zum Einsatz.

Die Erfindung soll nachfolgend noch näher erläutert werden.

N.N'-Bis-salicyloyl-hydrazin mit verminderter Augenreizwirkung wird beispielsweise folgendermaßen hergestellt :

a) Salicylsäurehydrazid wird in einem Überschuß an Salicylsäurealkylester in Anwesenheit katalytischer Mengen eines primären, sekundären oder tertiären Amins, einer aminogruppenhaltigen Verbindung oder eines Ammoniumsalzes eines Amins oder einer aminogruppenhaltigen Verbindung solange erhitzt, bis das N.N'-Bis-salicyloyl-hydrazin in maximaler Menge ausfällt. Nach dem Abkühlen wird abgesaugt, mit Alkohol gewaschen und getrocknet. Erforderlichenfalls kann durch Umkristallisieren noch weiter gereinigt werden.

b) Hydrazinhydrat wird in einem Überschuß an Salicylsäurealkylester in Anwesenheit katalytischer Mengen eines primären, sekundären oder tertiären Amins, einer aminogruppenhaltigen Verbindung oder eines Ammoniumsalzes eines Amins oder einer aminogruppenhaltigen Verbindung solange erhitzt, bis das N.N'-Bis-salicyloyl-hydrazin in maximaler Menge ausfällt. Nach dem Abkühlen wird abgesaugt, mit Alkohol gewaschen und getrocknet. Falls erforderlich, kann durch Umkristallisieren gereinigt werden.

Die Überprüfung der augenreizenden Wirkung des N.N'-Bis-salicyloyl-hydrazinserfolgt nach der sogenannten Testmethode 2. Dabei werden je Versuchsreihe sechs Kaninchen 5 Tage lang täglich 0,1 g Substanz in den Bindehautsack des rechten Auges appliziert. Bei drei der jeweiligen sechs Versuchstiere einer Versuchsreihe wird nach 1 Stunde der Bindehautsack mit physiologischer Kochsalzlözung gespült, wobei darauf geachtet wird, daß die Substanz vollständig entfernt wird. Die restlichen drei Versuchstiere der gleichen Versuchsreihe werden nicht weiter behandelt.

Bei diesen Untersuchungen wurde gefunden, daß bei Kaninchen, die mit dem bereits genannten, durch Umkristallisieren gereinigten Produkt behandelt werden, neben einer starken Rötung der Bindehaut eine starke Trübung der Hornhaut auftritt, die im Verlauf von drei Wochen nach Beendigung der Applikation nur sehr langsam zurückgeht. Mit N.N'-Bis-salicyloyl-hydrazin gemäß vorliegender Erfindung tritt dagegen nur eine vorübergehende, relativ schwache Rötung der Bindehaut und eine vergleichsweise geringe Trübung der Hornhaut auf. Bei der Verwendung des erfindungsgemäßen Produktes ergibt sich somit eine deutliche Verbesserung, d. h. eine stark verminderte Reizwirkung.

**Patentansprüche**

1. Verwendung von aus Salicylsäurealkylester und Hydrazin oder aus Salicylsäurealkylester und Salicylsäurehydrazid, gegebenenfalls in Gegenwart eines Katalysators, hergestelltem N.N'-Bis-salicyloyl-hydrazin als Metalldesaktivator für mit Kupfer in Berührung stehende oder Kupfer bzw. Kupferionen enthaltende organische Materialien.

2. Verwendung von N.N'-Bis-salicyloyl-hydrazin nach Anspruch 1 als Metalldesaktivator in Polymeren, insbesondere Reaktionsharzen, Elastomeren und vernetzten Polyolefinen.

**Claims**

1. The use of N.N'-bis-salicyloyl-hydrazine, produced from salicylic acid alkyl ester and hydrazine, or from salicylic acid alkyl ester and salicylic acid hydrazide, if necessary in the presence of a catalyst, as a metal deactivator for organic materials which are in contact with copper, or which contain copper or copper ions.

2. The use of N.N'-bis-salicyloyl-hydrazine as claimed in Claim 1 as a metal deactivator in polymers, in particular reaction resins, elastomers and cross-linked polyolefines.

**Revendications**

1. Utilisation de la N,N'-bis-salicyloyl-hydrazine préparée à partir d'un ester alcoylique d'acide salicylique et d'hydrazine ou d'un ester alcoylique d'acide salicylique et d'hydrazide d'acide salicylique, le cas échéant en présence d'un catalyseur, comme désactiveur de métaux pour des matériaux organiques en contact avec du cuivre, ou contenant du cuivre, ou des ions cuivre.

2. Utilisation de la N,N'-bis-salicyloyl-hydrazine suivant la revendication 1, comme désactiveur de métaux dans des polymères, notamment dans des résines de réaction, des élastomères et des polyoléfines réticulées.